# EUROPÄISCHE PATENTSCHRIFT

(11) **EP 4 199 672 B1**
(45) Veröffentlichungstag und Bekanntmachung des Hinweises auf die Patenterteilung: **04.03.2026**
(21) Anmeldenummer: 22204323.4
(22) Anmeldetag: 28.10.2022
(51) Int. Cl.: H05K 7/20

(54) **KONDENSATABLEITVORRICHTUNG, ELEKTRONIKBAUGRUPPE UND VERFAHREN ZUR HERSTELLUNG EINER KONDENSATABLEITVORRICHTUNG**
CONDENSATE DRAINAGE DEVICE, ELECTRONICS ASSEMBLY AND METHOD FOR PRODUCING A CONDENSATE DRAINAGE DEVICE
DISPOSITIF DE CONDENSATION DE CONDENSAT, ENSEMBLE ÉLECTRONIQUE ET PROCÉDÉ DE FABRICATION D'UN DISPOSITIF DE CONDENSATION DE CONDENSAT

(30) Priorität: 15.12.2021 DE 102021133332
(43) Veröffentlichungstag der Anmeldung: 21.06.2023
(73) Patentinhaber: ebm-papst Mulfingen GmbH & Co. KG, 74673 Mulfingen (DE)
(72) Erfinder: KRANER, Denis, 97980 Bad Mergentheim (DE); GOCYLA, Sebastian, 74722 Buchen (DE); ROST, Christian, 97993 Creglingen (DE); RENNER, Alexander, 74653 Künzelsau-Weldingsfelden (DE)
(74) Vertreter: Staeger & Sperling Partnerschaftsgesellschaft mbB

(56) Entgegenhaltungen:
- EP-A1- 3 910 253
- DE-A1- 102019 204 569

## Beschreibung

Die Erfindung betrifft Kondensatableitvorrichtung zur Ableitung von Kondensat von einem Bauteil, Elektronikbaugruppe mit einem Bauteil und einer solchen Kondensatableitvorrichtung sowie ein Verfahren zur Herstellung einer solchen Kondensatableitvorrichtung.

Aus dem Stand der Technik ist eine Vielzahl von Bauteilen bekannt, welche eine Kühlvorrichtung aufweisen. Dabei kann es insbesondere an aktiv gekühlten Bauteilen, welche beispielsweise durch eine Wasserkühlung gekühlt werden, bei einer zu starken Kühlung zu einer Kondensation kommen, bei welcher sich also ein Kondensat an dem Bauteil bildet.

Zu einer solchen Kondensation kann es insbesondere kommen, wenn das aktiv gekühlte Bauteil, bei welchem es sich insbesondere um eine Elektronik und beispielsweise um eine Leistungselektronik handelt, selbst nicht in Betrieb ist, sodass von diesem keine überschüssige Wärme abgeführt werden muss bzw. kann.

Durch ein sich auf dem Bauteil bildendes Kondensat kann es an diesem zu einer Korrosion und zu Kurzschlüssen kommen, sodass das Bauteil also durch das Kondensat beschädigt wird.

Um eine solche Beschädigung zu vermeiden, sind bereits verschiedene Gegenmaßnahmen bekannt.

Beispielsweise ist vorgesehen, das Bauteil zumindest teilweise mit einer Vergussmasse einzukapseln, sodass es nicht an dem Bauteil selbst, sondern an der Vergussmasse zu der Kondensation kommt. Dabei wird das Kondensat jedoch meist nicht von der Vergussmasse abgeführt, sodass dies an zu dem Bauteil benachbarten Bereichen oder an nicht eingekapselten Bereichen des Bauteils zu Fehlern und Schäden führen kann.

Kondensatableitvorrichtungen sind zudem beispielsweise aus dem Dokument EP 3 910 253 A1 bekannt.

Der Erfindung liegt deshalb die Aufgabe zugrunde, die vorgenannten Nachteile zu überwinden und eine Kondensatableitvorrichtung, eine Elektronikbaugruppe sowie ein Verfahren zur Herstellung bereit zu stellen, wobei ein Kondensat vollständig fluidtechnisch von dem Bauteil getrennt und vorzugsweise unabhängig von einer räumlichen Orientierung des Bauteils und/oder der Kondensatableitvorrichtung abführbar sein soll.

Diese Aufgabe wird durch die Merkmalskombination gemäß Patentanspruch 1 gelöst.

Erfindungsgemäß wird daher eine Kondensatableitvorrichtung zur Abführung von Kondensat von zumindest einem gekühlten Bauteil vorgeschlagen. Bei dem zumindest einen Bauteil handelt es sich insbesondere um eine gekühlte Elektronik bzw. Elektronikbauteile, wie beispielsweise eine Leistungselektronik, welche durch eine Wasserkühlung gekühlt sein kann. Der Einfachheit halber wird im Weiteren von einem (einzelnen) Bauteil gesprochen, wobei dieses jeweils als zumindest ein Bauteil zu verstehen ist. Ein solches Bauteil weist eine Oberfläche auf, an welcher es zumindest ohne die erfindungsgemäße Kondensatableitvorrichtung zu einer Kondensatbildung kommen kann. Erfindungsgemäß ist vorgesehen, dass die Kondensatableitvorrichtung ein Wärmeleitelement mit einer Kondensationsfläche aufweist. Das Wärmeleitelement ist insbesondere aus einem elektrisch nicht leitfähigen Material gebildet und liegt vorzugsweise eng und unmittelbar an der Oberfläche des Bauteils an, sodass zwischen dem Bauteil und insbesondere der Oberfläche des Bauteils und dem Wärmeleitelement kein Hohlraum gebildet ist, in welchem es zu einer Kondensation kommen kann. Das Wärmeleitelement ist ausgebildet, die Oberfläche des Bauteils zumindest abschnitts- bzw. teilweise und insbesondere vollständig abzudecken und eine an der Oberfläche des Bauteils zu einer Kondensation führende Kälte auf die Kondensationsfläche zu übertragen, sodass es nicht auf der Oberfläche des Bauteils, sondern auf der Kondensationsfläche zu der Kondensatbildung kommt. Zur gezielten Steuerung der Kondensation kann die Kondensationsfläche kleiner sein als die Oberfläche des Bauteils. Weiter weist die erfindungsgemäße Kondensatableitvorrichtung ein Gehäuse auf, welches vorzugsweise aus einem im Vergleich zu dem Wärmeleitelement schlecht wärmeleitenden Material gebildet ist. Das Gehäuse ist mit zumindest einer Kondensatableitung, vorzugsweise jedoch mehreren Kondensatableitungen und/oder einer Kondensatkammer zur Sammlung bzw. Aufnahme eines sich an der Kondensationsfläche bildenden Kondensats vorgesehen. Die zumindest eine Kondensatableitung bestimmt bzw. definiert jeweils zumindest einen vorbestimmten und fluidtechnisch von dem Bauteil getrennten Strömungspfad zur Ableitung des Kondensats aus dem Gehäuse.

Dadurch kommt es im Falle einer Kondensation nicht mehr an dem Bauteil selbst, sondern gezielt an der dafür vorgesehenen Kondensationsfläche zur Bildung des Kondensats, von welcher es mittels der Kondensationsableitung(en) gezielt abgeführt wird. Entsprechend kommt es an dem Bauteil nicht mehr zu Korrosion, Kurzschlüssen oder anderen Fehlern durch das Kondensat.

Der grundlegende Gedanke der Erfindung ist es, die Kondensation in einem definierten Bereich, der Kondensationsfläche, zuzulassen und gleichzeitig durch Wärmeaustausch mit der Umgebung den Betauungsbereich zu minimieren und von dem Bauteil, beispielsweise einer Elektronik, abzukapseln. Um den Bereich in dem die Kondensation zugelassen wird zu schützen, wird das Bauteil gegenüber diesem mittels einer Vergussmasse abgedichtet und vor Schäden/Kurzschlüssen geschützt.

Durch den mittels der Kondensationsfläche definierten Kondensationsbereich und mehreren Kondensatableitungen ist es gemäß einer im Weiteren ausführlicher erläuterten Weiterbildung zudem möglich, die zu schützende Elektronik bzw. das Bauteil in verschiedenen Einbaulagen zu montieren. Das Kondensat wird in diesen Einbaulagen immer von der Elektronik bzw. dem Bauteil weggeführt.

Gemäß einer vorteilhaften Variante kann vorgesehen sein, dass das Gehäuse ein Unterteil und/oder ein Oberteil aufweist, welche ausgebildet sind, das Bauteil insbesondere im Bereich der Oberfläche von zwei gegenüberliegenden Seiten zu umschließen.

Das Bauteil kann beispielsweise aus einer Leiterplatte und einem darauf vorgesehenen Leistungsmodul gebildet sein, welches auf der Leiterplatte kontaktiert ist und auf einer von der Leiterplatte abgewandten Seite die Kühlung aufweist. Durch eine zu starke Kühlung bzw. eine Kühlung des Leistungsmoduls bei deaktiviertem Leistungsmodul kann es an einer von dem Leistungsmodul abgewandten Seite der Leiterplatte zu der Kondensation kommen, sodass die Oberfläche des Bauteils, an welcher es zur Kondensation kommen kann, gleich der von dem Leistungsmodul abgewandten Oberfläche der Leiterplatte im Bereich des Leistungsmoduls ist.

Das zweiteilige Gehäuse der Kondensatableitvorrichtung kann entsprechend vorsehen, dass das Unterteil des Gehäuses an die Kühlung angrenzt und das Leistungsmodul an einer zu der Kühlung weisenden Seite der Leiterplatte umschließt, wobei das Oberteil des Gehäuses an der von der Kühlung abgewandten Seite der Leiterplatte vorgesehen ist und mithin die Oberfläche, an welches es zu der Kondensation kommen kann, umschließt.

Weiter ist vorzugsweise vorgesehen, dass die Kondensationsfläche in der Kondensatkammer freiliegt, also insbesondere frei von dem Gehäuse bzw. einem Material des Gehäuses ist, und einen Teil einer die Kondensatkammer begrenzenden Fläche bildet. Entsprechend wird die Kondensatkammer abschnittsweise durch das Gehäuse und abschnittsweise durch die Kondensationsfläche begrenzt.

Zur Ableitung des Kondensats ist vorzugsweise vorgesehen, dass die zumindest eine Kondensatableitung bzw. jeder der Kondensatableitungen ausgebildet ist, ein sich auf der Kondensationsfläche bildendes und in der Kondensatkammer sammelndes Kondensat schwerkraftgefördert entlang dem Strömungspfad fluidtechnisch getrennt von dem Bauteil aus dem Gehäuse abzuleiten. Hierfür kann eine jeweilige Kondensatableitung auch Führungsrinnen und/oder Fluidkanäle aufweisen durch welche das Kondensat aus dem Gehäuse leitbar ist.

Grundsätzlich kann ein Bauteil, von welchem die erfindungsgemäße Kondensatableitvorrichtung das Kondensat ableiten soll, in verschiedenen Einbaulagen bzw. Orientierungen im Raum angeordnet sein. Auch kann es insbesondere bei instationären Systemen während des Betriebs zu einer Änderung der Orientierung im Raum kommen. Beispielhaft kann das Bauteil in einer ersten räumlichen Orientierung oder in einer sich dazu unterscheidenden zweiten räumlichen Orientierung angeordnet werden bzw. seine räumliche Orientierung von der ersten in die zweite ändern. Um eine Ableitung des Kondensats in der ersten und der zweiten Orientierung und vorzugsweise in allen möglichen Orientierungen zu gewährleisten, sieht eine vorteilhafte Weiterbildung vor, dass das Gehäuse eine erste Kondensatableitung, welche zumindest einen ersten vorbestimmten und fluidtechnisch von dem Bauteil getrennten Strömungspfad zur Ableitung des Kondensats aus dem Gehäuse bestimmt, und eine zweite Kondensatableitung aufweist, welche zumindest einen zweiten vorbestimmten und fluidtechnisch von dem Bauteil getrennten Strömungspfad zur Ableitung des Kondensats aus dem Gehäuse bestimmt. Die Kondensatableitvorrichtung kann an dem Bauteil fixiert sein und ändert die relative Lage bezüglich dem Bauteil vorzugsweise nicht, sodass es mit dem Bauteil in der ersten räumlichen Orientierung oder in der sich dazu unterscheidenden zweiten räumlichen Orientierung anordenbar ist bzw. mit dem Bauteil die räumliche Orientierung ändert. Zur Ableitung des Kondensats ist vorgesehen, dass das Kondensat bei der ersten räumlichen Orientierung über die erste Kondensatableitung und/oder über die zweite Kondensatableitung sowie bei der zweiten räumlichen Orientierung über die zweite Kondensatableitung und/oder über die die erste Kondensatableitung aus dem Gehäuse leitbar ist.

Dabei kann vorgesehen sein, dass das Kondensat bei der ersten Orientierung ausschließlich über die erste Kondensatableitung und bei der zweiten Orientierung ausschließlich über die zweite Kondensatableitung abfließen kann. Beispielsweise kann dies der Fall sein, wenn das Bauteil von einer ersten Orientierung um 90° oder 180° um eine zu einer Hochachse des Raumes orthogonale Raumachse in eine zweite Orientierung gedreht wird.

Vorzugsweise ist für eine Vielzahl von Orientierungen und weiter vorzugsweise für jede mögliche räumliche Orientierung des Bauteils zumindest eine zugehörige Kondensatableitung vorgesehen, durch welche das Kondensat insbesondere schwerkraftgefördert aus dem Gehäuse leitbar ist.

Das Gehäuse und seine Kondensatkammer können insbesondere auch trichterförmig ausgebildet und an einer der Kondensationsfläche gegenüberliegenden Seite geöffnet sein. Dadurch bildet die den Trichter bildende Außenwandung des Gehäuses eine Vielzahl von Kondensatableitungen.

Vorzugsweise weitet sich die Kondensatkammer durch die Trichterform mit zunehmenden Abstand zu der Kondensationsfläche auf.

Um zu verhindern, dass sich das Kondensat am Boden der Kondensatkammer bzw. an der Kondensationsfläche sammelt, kann auch angrenzend an die Kondensationsfläche eine oder mehrere Kondensatableitungen vorgesehen sein. Vorzugsweise weist die Kondensatkammer eine rechteckige Grundform auf, wobei in zumindest einer der Ecken und vorzugsweise jeder der Ecken jeweils eine Kondensatableitung vorgesehen sein kann. Ausgehend von der Kondensationsfläche kann jeweils eine Führungsrinne vorgesehen sein, welche zu jeweils einer Kondensatableitung führt, sodass das Kondensat von der Kondensationsfläche durch die Führungsrinne in eine jeweilige Kondensatableitung fließen kann. Solche Führungsrinnen können beispielsweise durch eine oder mehrere schiefe Ebenen gebildet sein.

Dabei kann das Bauteil bzw. beispielsweise eine Leiterplatte als Teil des Bauteils eine Öffnung aufweisen, durch welche hindurch die zumindest eine Kondensatableitung bzw. eine der Kondensatableitungen verlaufen kann.

Erfindungsgemäß ist das Wärmleitelement aus einer Vergussmasse gebildet, welche entsprechend bei der Verarbeitung noch fließfähig bzw. flüssig ist und dann zu dem Wärmeleitelement aushärten kann.

Das Gehäuse weist zudem eine Formkammer zur Aufnahme des Wärmeleitelements auf, wobei die Formkammer vollständig von dem Wärmeleitelement ausgefüllt ist. Dabei kann eine Wandung der Formkammer abschnittsweise durch das Gehäuse und abschnittsweise durch das Bauteil und/oder die Kühlvorrichtung gebildet werden. Weiter ist die Formkammer ausgebildet, das Bauteil zumindest abschnittsweise und die Oberfläche des Bauteils vollständig einzuhausen. Die Formkammer bildet eine Gussform für die Vergussmasse. Entsprechend ist die Formkammer vorzugsweise ausschließlich zu der Kondensatkammer hin geöffnet, sodass die Vergussmasse durch die Kondensatkammer in die Formkammer einbringbar ist und die zu dem Wärmeleitelement ausgehärtete Vergussmasse die Öffnung der Formkammer zu der Kondensatkammer verschließt und die Kondensationsfläche bildet.

Um zusammen mit dem Bauteil eine fluiddichte Formkammer als Gussform für die Vergussmasse bilden zu können, kann gemäß einer weiteren Ausführungsvariante vorgesehen sein, dass das Gehäuse zumindest einen Dichtabschnitt aufweist, welcher insbesondere als eine Dichtlippe beispielswiese zur Anlage an dem Bauteil ausgebildet ist. Der Dichtabschnitt ist ausgebildet, die als Gussform ausgebildete Formkammer insbesondere mit dem Bauteil zusammenwirkend gegenüber einer Umgebung und vorzugsweise fluiddicht abzudichten. Weist das Gehäuse ein Unterteil und ein Oberteil auf bzw. ist das Gehäuse mehrteilig ausgebildet, kann auch an jedem Teil oder zumindest an mehreren Teilen des Gehäuses ein insbesondere als eine Dichtlippe ausgebildeter Dichtabschnitt vorgesehen sein.

Ein weiterer Aspekt betrifft eine Elektronikbaugruppe mit einer Kühlvorrichtung, zumindest einem elektrischen Bauteil und einer erfindungsgemäßen Kondensatableitvorrichtung. Dabei kann die Elektronikbaugruppe auch als Elektronikeinheit bezeichnet werden. Die Kühlvorrichtung zur Kühlung des zumindest einen Bauteils ist an diesem bzw. an diesen angeordnet und das zumindest eine Bauteil weist eine Oberfläche auf, an welcher es durch die Kühlung mittels der Kühlvorrichtung zumindest ohne die Kondensatableitvorrichtung zu einer Kondensatbildung kommen kann, was entsprechend durch die erfindungsgemäße Kondensatableitvorrichtung verhindert wird.

Vorzugsweise ist die Elektronikbaugruppe mit einem Baugruppengehäuse vorgesehen, welches insbesondere das zumindest eine Bauteil mit der Kondensatableitvorrichtung umgibt. Das Gehäuse der Kondensatableitvorrichtung ist dabei insbesondere vollständig innerhalb des Baugruppengehäuses angeordnet. Die zumindest eine Kondensatableitung ist jeweils ausgebildet, das Kondensat aus dem Baugruppengehäuse abzuführen. Entsprechend kann die Kondensatkammer über jede der Kondensatableitungen fluid- bzw. strömungstechnisch mit einer das Baugruppengehäuse umgebenden Umgebung verbunden sein, sodass das Kondensat vorzugsweise schwerkraftgefördert in die Umgebung geleitet werden kann.

Zudem betrifft ein wichtiger Aspekt der Erfindung ein Verfahren zur Herstellung einer erfindungsgemäßen Elektronikbaugruppe. Das Gehäuse wird dabei die Formkammer bildend an dem zumindest einen Bauteil anliegend angeordnet und vorzugsweise gegenüber dem zumindest einen Bauteil abgedichtet und weiter vorzugsweise flüssigkeitsdicht abgedichtet, sodass die Formkammer ausschließlich zur Kondensatkammer hin geöffnet ist und Flüssigkeit (Kondensat) nur über die Kondensatkammer abfließen bzw. abgeführt werden kann. Eine beispielsweise gasdichte Abdichtung ist nicht notwendig. Anschließend wird durch eine Öffnung zur Kondensatkammer eine sich schwerkraftgefördert in der Formkammer verteilende und die Formkammer vollständig ausfüllende Vergussmasse in die Formkammer gefüllt, welche nach einem Aushärten der Vergussmasse das Wärmeleitelement bildet.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine perspektivische Ansicht einer an einem Bauteil montierten Kondensatableitvorrichtung;
- Fig. 2: eine Aufsicht auf die Kondensatableitvorrichtung;
- Fig. 3: einen ersten Schnitt durch die Kondensatableitvorrichtung;
- Fig. 4: einen zweiten Schnitt durch die Kondensatableitvorrichtung.

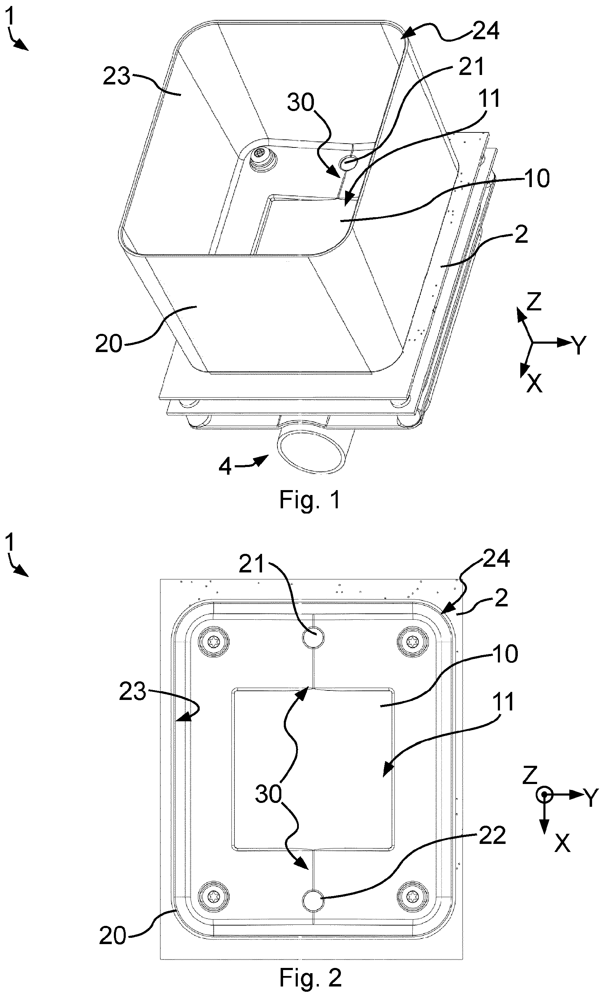

Die Figuren 1 bis 4 sind beispielhaft schematisch und zeigen eine Kondensatableitvorrichtung 1 bzw. eine Elektronikbaugruppe mit einer Kühlvorrichtung 4, ein durch die Kühlvorrichtung 4 gekühltes Bauteil 2 sowie mit einer Kondensatableitvorrichtung 1. Gleiche Bezugszeichen in den Figuren weisen auf gleiche funktionale und/oder strukturelle Merkmale hin. Obgleich nicht jedes Bezugszeichen in jeder Figur verwendet ist, sind entsprechende Merkmale vorhanden. Entsprechend gilt die nachfolgende Beschreibung für alle Figuren.

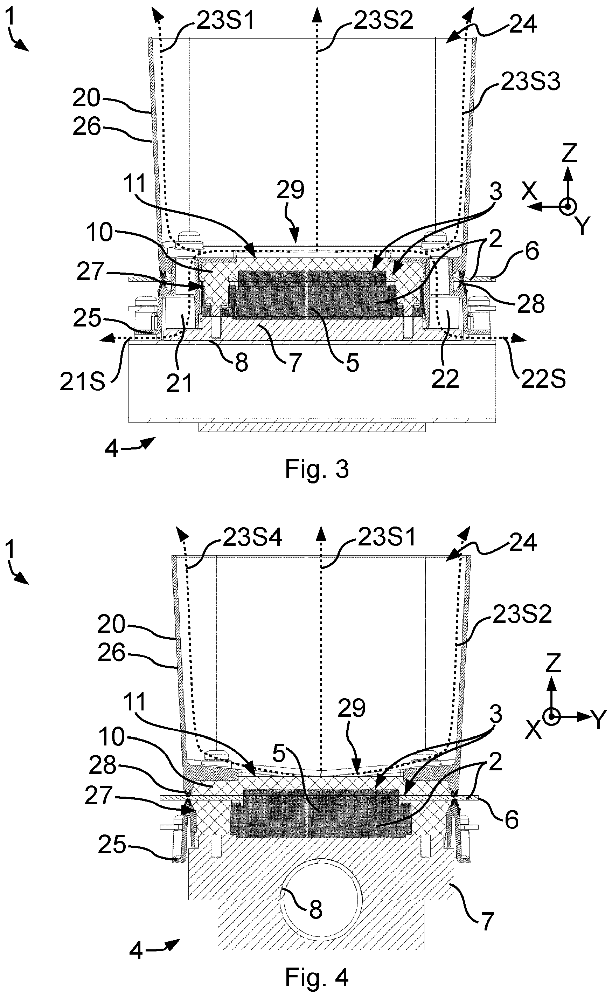

Das Bauteil 2 weist, wie insbesondere in den Figuren 3 und 4 ersichtlich, beispielhaft eine Leistungselektronik 5 auf, welche an einer Leiterplatte 6 elektrisch kontaktiert ist.

Im Betrieb kann die Leistungselektronik 5 sehr warm werden, sodass diese durch die Kühlvorrichtung 4 gekühlt werden muss. Hierfür weist die Kühlvorrichtung 4 einen Kühlkörper 7 auf, welcher die Wärme von der Leistungselektronik 5 abführt und auf ein Kühlrohr 8 bzw. auf eine das Kühlrohr 8 durchströmende Kühlflüssigkeit überträgt.

Meist werden durch die Kühlflüssigkeit eine Vielzahl von Komponenten gekühlt, sodass die Kühlflüssigkeit auch kühlend an dem Kühlkörper 7 bzw. dem Bauteil 2 vorbei strömt, wenn die Leistungselektronik 5 deaktiviert d.h. ausgeschaltet ist und entsprechend keine Wärme abgibt.

Dadurch kommt es an dem Bauteil 2 zu niedrigen Temperaturen, welche zu einer Kondensation am Bauteil 2 und insbesondere zu einer Kondensation an einer Oberfläche 3 des Bauteils 2 führen können.

Zur gezielten Abführung eines sich ansonsten an dem Bauteil 2 bildenden Kondensats ist die Kondensatableitvorrichtung 1 vorgesehen.

Diese weist ein Gehäuse 20 auf, welches aus einem Oberteil 26 und einem Unterteil 25 besteht.

Das Unterteil 25 ist auf einer ersten Seite bzw. einer Unterseite der Leiterplatte 6 vorgesehen, auf welcher auch die Leistungselektronik 5 und die Kühlvorrichtung 4 angeordnet sind. Dabei umläuft das Unterteil 25 die Leistungselektronik in eine Umfangsrichtung um eine in der Bildebene liegende Hochachse Z und schließt dicht mit dem Kühlkörper 7 und mittels einer Dichtlippe 28 dicht mit der Leiterplatte 6 ab.

Das Oberteil 26 ist bezüglich des Unterteils 25 auf der gegenüberliegenden Seite der Leiterplatte 6 angeordnet und dichtet mittels einer weiteren Dichtlippe 28 mit der Leiterplatte 6 ab.

Dadurch bestimmten das Oberteil 26 und das Unterteil 25 des Gehäuses 20 gemeinsam eine fluiddichte Formkammer 27 um die Leistungselektronik 5, an welcher die Oberfläche 3 des Bauteils liegt, an der es zu einer Kondensation kommen kann. Die Formkammer 27 ist dabei ausschließlich durch eine Öffnung 29 zu einer durch das Gehäuse 20 gebildeten Kondensatkammer 24 geöffnet. Dadurch bildet die Formkammer 27 eine Gussform, in welcher die Leistungselektronik 5 und Abschnitte der Leiterplatte 6 oder allgemeiner ein Teil des Bauteils 2 und vollständig die Oberfläche 3, an welcher es zu einer Kondensation kommen kann, angeordnet bzw. aufgenommen sind.

In die eine Gussform bildende Formkammer 27 wird dann im Rahmen der Herstellung eine noch fließfähige bzw. flüssige Vergussmasse eingefüllt, welche sich in der Formkammer 27 verteilt und diese vollständig ausfüllt. Durch Aushärten der Gussmasse bildet diese ein Wärmeleitelement 10, welches die Oberfläche 3, an welcher es zu einer Kondensation kommen kann, vollständig abdeckt und somit eine Kondensation an dieser verhindert.

Da das Gehäuse 20 mit Ausnahme des Bereichs der Öffnung 29 unmittelbar an dem Wärmeleitelement 10 anliegt und vorzugsweise deutlich schlechter wärmeleitfähig ist als das Wärmeleitelemente 10, kann es nur im Bereich der Öffnung 29 bzw. der im Bereich der Öffnung 29 gebildeten Kondensationsfläche 11 zu einer Kondensation kommen. Folglich wird die Kondensation am Bauteil 2 verhindert und gezielt an der Kondensationsfläche 11 hervorgerufen.

Die Kondensationsfläche 11 liegt in der Kondensatkammer 24 bzw. bildet einen Teil der die Kondensatkammer 24 begrenzenden Fläche. Entsprechend wird ein an der Kondensationsfläche 11 gebildetes Kondensat in der Kondensatkammer 24 gesammelt. Um einen Fehler und eine Beschädigung umliegender Bereiche zu verhindern, muss das Kondensat aus der Kondensatkammer 24 gezielt und sicher abgeführt werden können.

In der beispielsweise in den Figuren 3 und 4 gezeigten Einbaulage, in welcher die Schwerkraft parallel der Hochachse Z und in der Darstellungsebene nach unten wirkt, kann das Kondensat von der Kondensationsfläche 11 über dafür ausgebildete Führungsrinnen 30 zu einer ersten und zweiten Kondensatableitung 21, 22 abgeführt werden, welche insbesondere in den Figuren 1 und 2 erkennbar sind.

Dabei werden die Führungsrinnen 30 und die Kondensatableitungen 21, 22 von dem Gehäuse 20 gebildet. Durch die erste und zweite Kondensatableitung 21, 22 kann das Kondensat fluidtechnisch von dem Bauteil 2 getrennt abgeführt werden, wobei hierfür Ausnehmungen in dem Bauteil 2 bzw. in der Leiterplatte 6 des Bauteils vorgesehen sind, durch welche hindurch die erste und zweite Kondensatableitung 21, 22 verläuft.

Ein wichtiger Aspekt einer besonders vorteilhaften Weiterbildung der Erfindung ist es, das Kondensat nicht nur in einer einzelnen vorbestimmten Lage aus der Kondensatkammer 24 abführen zu können, sondern das Kondensat in einer Vielzahl von Lagen aus der Kondensatkammer 24 abführen zu können, sodass die Kondensatableitvorrichtung 1 an verschieden positionierten Bauteilen 2 verwendbar ist oder zusammen mit dem Bauteil 2 die räumliche Orientierung bzw. die Lage im Raum ändern kann, wobei weiterhin eine sichere Kondensatableitung gewährleistet sein soll.

Die Kondensatkammer 24 ist hierfür als ein offener Trichter ausgebildet, welcher an einer entlang der Hochachse Z von dem Bauteil 2 abgewandten Seite geöffnet ist.

Ausgehend von einer Ausgangsstellung, wie sie in den Figuren 3 und 4 dargestellt ist, kann das Kondensat schwerkraftgefördert zunächst durch die erste und zweite Kondensatableitung 21, 22 und entlang der durch diese definierten Strömungspfade 21S, 22S abfließen. Wird das Bauteil 2 mit der Kondensatableitvorrichtung 1 um die Raumachse Y gedreht oder mit diesem gedreht angeordnet, kann das Kondensat bis zu einem Grenzwinkel durch die erste Kondensatableitung 21 oder die zweite Kondensatableitung 22 abfließen. Überschreitet die Drehung den Grenzwinkel, kann das Kondensat nicht mehr in die erste oder zweite Kondensatableitung 21, 22 eindringen, fließt jedoch über eine durch die trichterform der Kondensatkammer 24 gebildete Kondensatableitung 23 ab, wobei die Kondensatkammer 24 durch die nach oben offene Form vorliegend eine Vielzahl möglicher Kondensatableitungen 23 bildet. Beispielhaft sind hierfür vier mögliche Strömungspfade 23S1 bis 23S4 dargestellt. Überschreitet die Drehung um die Raumachse Y den Grenzwinkel kann das Kondensat abhängig von der Drehrichtung um die Raumachse Y entlang des Strömungspfades 23S1 oder entlang des Strömungspfades 23S3 aus der Kondensatkammer 24 abfließen.

Vorliegend ist der Grenzwinkel beispielhaft mit ca. 90° anzunehmen.

Entsprechend kann die Kondensatableitvorrichtung 1 beliebig um die Raumachse Y gedreht werden oder gedreht angeordnet werden, wobei jeweils eine sichere und von dem Bauteil fluidtechnisch getrennte Abführung des Kondensats gewährleistet ist.

Beispielhaft sind auch zwei weitere Strömungspfade 23S2 und 23S4 dargestellt, welche bei einer Drehung der Kondensatableitvorrichtung 1 um die Raumachse X eine Kondensatableitung aus der Kondensatkammer 24 ermöglichen.

Vorliegend nicht gezeigt, können neben der ersten und zweiten Kondensatableitung 21, 22 auch weitere Kondensatableitungen vorgesehen sein, welche durch die Leiterplatte 6 hindurchführen.

In den Figuren nicht dargestellt, kann die gesamte Elektronikbaugruppe ein Gehäuse aufweisen, welches das Bauteil 2 und die Kondensatableitvorrichtung 1 einhaust. Vorzugsweise sind die Kondensatableitungen 21, 22, 23 aus dem Gehäuse herausführend angeordnet, sodass das Kondensat entlang der Strömungspfade 21S, 22S, 23S1, 23S2, 23S3, 23S4 und beispielsweise mittels Schläuche aus dem Gehäuse geführt werden kann, ohne fluidtechnisch mit dem Bauteil in Kontakt kommen zu können.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Kondensatableitvorrichtung (1) zur Abführung von Kondensat von zumindest einem gekühlten Bauteil (2), bei welchem es sich insbesondere um eine gekühlte Elektronik handelt und welches eine Oberfläche (3) aufweist, an welcher es zu einer Kondensatbildung kommen kann,
wobei die Kondensatableitvorrichtung (1) ein Wärmeleitelement (10) mit einer Kondensationsfläche (11) aufweist, welches ausgebildet ist, die genannte Oberfläche (3) des zumindest einen Bauteils (2) zumindest teilweise abzudecken und eine an der genannten Oberfläche (3) des zumindest einen Bauteils (2) zu einer Kondensation führende Kälte auf die Kondensationsfläche (10) zu übertragen,
ferner aufweisend ein Gehäuse (20) mit zumindest einer Kondensatableitung (21, 22, 23),
wobei die zumindest eine Kondensatableitung (21, 22, 23) jeweils zumindest einen vorbestimmten und fluidtechnisch von dem zumindest einem Bauteil (2) getrennten Strömungspfad (21S, 22S, 23S1, 23S2, 23S3, 23S4) zur Ableitung eines sich an der Kondensationsfläche (11) bildenden Kondensats aus dem Gehäuse (20) bestimmt,
**dadurch gekennzeichnet, dass** das Wärmleitelement (10) aus einer Vergussmasse gebildet ist und
das Gehäuse (20) eine Formkammer (27) zur Aufnahme des Wärmeleitelements (10) aufweist,
wobei die Formkammer (27) vollständig von dem Wärmeleitelement (10) ausgefüllt ist und ausgebildet ist, das zumindest eine Bauteil (2) zumindest abschnittsweise und die genannte Oberfläche (3) des zumindest einen Bauteils (2) vollständig einzuhausen, und welche eine Gussform für die Vergussmasse bildet.

2. Kondensatableitvorrichtung nach Anspruch 1,
wobei das Gehäuse (20) ein Unterteil (25) und/oder ein Oberteil (26) aufweist, welche ausgebildet sind, das zumindest eine Bauteil (2) insbesondere im Bereich der genannten Oberfläche (3) von zwei gegenüberliegenden Seiten zu umschließen.

3. Kondensatableitvorrichtung nach Anspruch 1 oder 2,
wobei das Gehäuse (20) ferner eine Kondensatkammer (24) zur Sammlung des Kondensats aufweist.

4. Kondensatableitvorrichtung nach dem vorhergehenden Anspruch, wobei die Kondensationsfläche (11) in der Kondensatkammer (24) freiliegt und einen Teil einer die Kondensatkammer (24) begrenzenden Fläche bildet.

5. Kondensatableitvorrichtung nach einem der beiden vorhergehenden Ansprüche,
wobei die zumindest eine Kondensatableitung (21, 22, 23) ausgebildet ist, ein sich auf der Kondensationsfläche (11) bildendes und in der Kondensatkammer (24) sammelndes Kondensat schwerkraftgefördert entlang dem Strömungspfad (21S, 22S, 23S1, 23S2, 23S3, 23S4) fluidtechnisch getrennt von dem zumindest einem Bauteil (2) aus dem Gehäuse (20) abzuleiten.

6. Kondensatableitvorrichtung nach einem der vorhergehenden Ansprüche,
wobei das zumindest eine Bauteil (2) in einer ersten räumlichen Orientierung oder in einer sich dazu unterscheidenden zweiten räumlichen Orientierung anordenbar ist,
wobei das Gehäuse (20) eine erste Kondensatableitung (21, 22, 23), welche zumindest einen ersten vorbestimmten und fluidtechnisch von dem zumindest einem Bauteil (2) getrennten Strömungspfad (21S, 22S, 23S1, 23S2, 23S3, 23S4) zur Ableitung des Kondensats aus dem Gehäuse (20) bestimmt,
und eine zweite Kondensatableitung (21, 22, 23) aufweist, welche zumindest einen zweiten vorbestimmten und fluidtechnisch von dem zumindest einem Bauteil (2) getrennten Strömungspfad (21S, 22S, 23S1, 23S2, 23S3, 23S4) zur Ableitung des Kondensats aus dem Gehäuse (20) bestimmt, und
wobei die Kondensatableitvorrichtung (1) mit dem zumindest einem Bauteil (2) in der ersten räumlichen Orientierung oder in der sich dazu unterscheidenden zweiten räumlichen Orientierung anordenbar ist, und
wobei das Kondensat bei der ersten räumlichen Orientierung über die erste Kondensatableitung (21, 22, 23) und/oder über die zweite Kondensatableitung (21, 22, 23) sowie bei der zweiten räumlichen Orientierung über die zweite Kondensatableitung (21, 22, 23) und/oder über die die erste Kondensatableitung (21, 22, 23) aus dem Gehäuse leitbar ist.

7. Kondensatableitvorrichtung nach einem der vorhergehenden Ansprüche,
wobei das Gehäuse (20) zumindest einen insbesondere durch eine Dichtlippe (28) gebildeten Dichtabschnitt aufweist, welcher ausgebildet ist, die als Gussform ausgebildete Formkammer (27) insbesondere mit dem zumindest einem Bauteil (2) zusammenwirkend gegenüber einer Umgebung abzudichten.

8. Elektronikbaugruppe mit einer Kühlvorrichtung (4), zumindest einem elektrischen Bauteil (2) und einer Kondensatableitvorrichtung (1) gemäß einem der vorhergehenden Ansprüche,
wobei die Kühlvorrichtung (4) zur Kühlung des zumindest einen Bauteils (2) an diesem angeordnet ist und das zumindest eine Bauteil (2) eine Oberfläche (3) aufweist, an welcher es durch die Kühlung mittels der Kühlvorrichtung (4) zu einer Kondensatbildung kommen kann.

9. Elektronikbaugruppe nach dem vorhergehenden Anspruch, ferner aufweisend ein Baugruppengehäuse,
wobei das Gehäuse (20) der Kondensatableitvorrichtung (1) insbesondere vollständig innerhalb des Baugruppengehäuses angeordnet ist und die zumindest eine Kondensatableitung (21, 22, 23) jeweils ausgebildet ist, das Kondensat aus dem Baugruppengehäuse abzuführen.

10. Verfahren zur Herstellung einer Elektronikbaugruppe gemäß einem der beiden vorhergehenden Ansprüchen und einer Kondensatableitvorrichtung (1) gemäß einem der Ansprüche 3 bis 7
wobei das Gehäuse (20) die Formkammer (27) bildend an dem zumindest einem Bauteil (2) anliegend angeordnet und insbesondere gegenüber dem zumindest einem Bauteil (2) abgedichtet wird, sodass die Formkammer (27) ausschließlich zur Kondensatkammer (24) hin geöffnet ist,
wobei durch eine Öffnung (29) zur Kondensatkammer (24) eine sich schwerkraftgefördert in der Formkammer (27) verteilende und die Formkammer (27) vollständig ausfüllende Vergussmasse in die Formkammer (27) gefüllt wird, welche nach einem Aushärten der Vergussmasse das Wärmeleitelement (10) bildet.

## Claims

1. A condensate draining device (1) for discharging condensate from at least one cooled component (2) which is in particular a cooled electronic system and has a surface (3) on which condensate formation can occur,
wherein the condensate draining device (1) has a heat conducting element (10) which has a condensation surface (11) and which is designed to at least partially cover said surface (3) of the at least one component (2) and to transfer a cold causing condensation on said surface (3) of the at least one component (2) to the condensation surface (11),
further having a housing (20) with at least one condensate drain (21, 22, 23),
wherein the at least one condensate drain (21, 22, 23) determines in each case at least one predetermined flow path (21S, 22S, 23S1, 23S2, 23S3, 23S4) which is fluidically separated from the at least one component (2) for draining off a condensate forming on the condensation surface (11) from the housing (20),
**characterized in that** the heat conducting element (10) is formed from a potting compound and
the housing (20) has a mold chamber (27) for accommodating the heat conducting element (10),
wherein the mold chamber (27) is completely filled by the heat conducting element (10) and is designed to enclose the at least one component (2) at least in certain sections and said surface (3) of the at least one component (2) completely, and forms a mold for the potting compound.

2. The condensate draining device according to claim 1,
wherein the housing (20) has a lower part (25) and/or an upper part (26), which are designed to enclose the at least one component (2) from two opposite sides, in particular in the region of said surface (3).

3. The condensate draining device according to claim 1 or 2,
wherein the housing (20) further has a condensate chamber (24) for collecting the condensate.

4. The condensate draining device according to the preceding claim,
wherein the condensation surface (11) in the condensate chamber (24) is exposed and forms part of a surface delimiting the condensate chamber (24).

5. The condensate draining device according to one of the two preceding claims,
wherein the at least one condensate drain (21, 22, 23) is designed to drain off a condensate forming on the condensation surface (11) and accumulating in the condensate chamber (24) from the housing (20) along the flow path (21S, 22S, 23S1, 23S2, 23S3, 23S4) such that it is fluidically separated from the at least one component (2).

6. The condensate draining device according to any one of the preceding claims,
wherein the at least one component (2) can be arranged in a first spatial orientation or in a second spatial orientation differing therefrom,
wherein the housing (20) has a first condensate drain (21, 22, 23) which determines at least one first predetermined flow path (21S, 22S, 23S1, 23S2, 23S3, 23S4) fluidically separated from the at least one component (2) for draining off the condensate from the housing (20),
and has a second condensate drain (21, 22, 23) which determines at least one second predetermined flow path (21S, 22S, 23S1, 23S2, 23S3, 23S4) fluidically separated from the at least one component (2) for draining off the condensate from the housing (20), and
wherein the condensate draining device (1) can be arranged with the at least one component (2) in the first spatial orientation or in the second spatial orientation differing therefrom, and
wherein in the first spatial orientation, the condensate can be guided out of the housing via the first condensate drain (21, 22, 23) and/or via the second condensate drain (21, 22, 23) and in the second spatial orientation via the second condensate drain (21, 22, 23) and/or via the first condensate drain (21, 22, 23).

7. The condensate draining device according to one of the preceding claims,
wherein the housing (20) has at least one sealing section which is formed in particular by a sealing lip (28) and which is designed to seal off the mold chamber (27) formed as a mold from an environment, in particular by cooperating with the at least one component (2).

8. An electronic assembly with a cooling device (4), at least one electrical component (2) and a condensate draining device (1) according to any one of the preceding claims,
wherein the cooling device (4) for cooling the at least one component (2) is arranged on the latter and the at least one component (2) has a surface (3) on which condensate formation can occur as a result of the cooling by means of the cooling device (4).

9. The electronic assembly according to the preceding claim,
further having an assembly housing,
wherein the housing (20) of the condensate draining device (1) is arranged in particular completely within the assembly housing and the at least one condensate drain (21, 22, 23) is designed in each case to discharge the condensate from the assembly housing.

10. A method for producing an electronic assembly according to any one of the two preceding claims and a condensate draining device (1) according to any one of claims 3 to 7,
wherein the housing (20) forming the mold chamber (27) is arranged resting against the at least one component (2) and is in particular sealed with respect to the at least one component (2) so that the mold chamber (27) is open exclusively towards the condensate chamber (24),
wherein through an opening (29) to the condensate chamber (24), a potting compound is filled into the mold chamber (27), which potting compound is distributed in the mold chamber (27) by gravity and completely fills the mold chamber (27) and forms the heat conducting element (10) after curing of the potting compound.

## Revendications

1. Dispositif (1) d'évacuation de condensat destiné à évacuer du condensat d'au moins un composant refroidi (2), lequel est notamment un composant électronique refroidi et présente une surface (3) sur laquelle de la condensation peut se former,
dans lequel le dispositif (1) d'évacuation de condensat présente un élément de conduction thermique (10) doté d'une surface de condensation (11), lequel est configuré pour recouvrir au moins partiellement ladite surface (3) dudit au moins un composant (2)
et pour transférer vers la surface de condensation (10) un froid provoquant une condensation au niveau de ladite surface (3) dudit au moins un composant (2),
comprenant en outre un boîtier (20) doté d'au moins une évacuation de condensat (21, 22, 23),
dans lequel ladite au moins une évacuation de condensat (21, 22, 23) définit respectivement au moins un chemin d'écoulement (21S, 22S, 23S1, 23S2, 23S3, 23S4) prédéterminé et séparé du point de vue fluidique dudit au moins un composant (2) pour l'évacuation, hors du boîtier (20), d'un condensat se formant sur la surface de condensation (11),
**caractérisé en ce que** l'élément de conduction thermique (10) est constitué d'une masse de coulée et
le boîtier (20) présente une chambre de moulage (27) pour recevoir l'élément de conduction thermique (10),
dans lequel la chambre de moulage (27) est entièrement remplie par l'élément de conduction thermique (10) et est configurée pour enserrer au moins par sections ledit au moins un composant (2) et entièrement ladite surface (3) dudit au moins un composant (2),
et laquelle définit un moule pour la masse de coulée.

2. Dispositif d'évacuation de condensat selon la revendication 1,
dans lequel le boîtier (20) présente une partie inférieure (25) et/ou une partie supérieure (26), lesquelles sont configurées pour enserrer ledit au moins un composant (2), notamment dans la zone de ladite
surface (3), à partir de deux côtés opposés.

3. Dispositif d'évacuation de condensat selon la revendication 1 ou 2,
dans lequel le boîtier (20) présente en outre une chambre de condensat (24) pour la collecte du condensat.

4. Dispositif d'évacuation de condensat selon la revendication précédente,
dans lequel la surface de condensation (11) est exposée dans la chambre de condensat (24) et définit une partie d'une surface délimitant la chambre de condensat (24).

5. Dispositif d'évacuation de condensat selon l'une des deux revendications précédentes,
dans lequel ladite au moins une évacuation de condensat (21, 22, 23) est configurée pour évacuer hors du boîtier (20), par gravité le long du chemin d'écoulement (21S, 22S, 23S1, 23S2, 23S3, 23S4) et de manière séparée du point de vue fluidique dudit au moins un composant (2), un condensat se formant sur la surface de condensation (11) et se collectant dans la chambre de condensat (24).

6. Dispositif d'évacuation de condensat selon l'une des revendications précédentes,
dans lequel ledit au moins un composant (2) peut être disposé selon une première orientation spatiale ou selon une deuxième orientation spatiale différente de celle-ci, dans lequel le boîtier (20) présente une première évacuation de condensat (21, 22, 23) qui définit au moins un premier chemin d'écoulement (21S, 22S, 23S1, 23S2, 23S3, 23S4) prédéterminé et séparé du point de vue fluidique dudit au moins un composant (2) pour l'évacuation du condensat hors du boîtier (20),
et présente une deuxième évacuation de condensat (21, 22, 23) qui définit au moins un deuxième chemin d'écoulement (21S, 22S, 23S1, 23S2, 23S3, 23S4) prédéterminé et séparé du point de vue fluidique dudit au moins un composant (2) pour l'évacuation du condensat hors du boîtier (20), et
dans lequel le dispositif (1) d'évacuation de condensat peut être disposé avec ledit au moins un composant (2) selon la première orientation spatiale ou selon la deuxième orientation spatiale différente de celle-ci, et
dans lequel le condensat peut être évacué hors du boîtier, selon la première orientation spatiale via la première évacuation de condensat (21, 22, 23) et/ou via la deuxième évacuation de condensat (21, 22, 23), ainsi que selon la deuxième orientation spatiale via la deuxième évacuation de condensat (21, 22, 23) et/ou via la première évacuation de condensat (21, 22, 23).

7. Dispositif d'évacuation de condensat selon l'une des revendications précédentes,
dans lequel le boîtier (20) présente au moins une section d'étanchéité formée notamment par une lèvre d'étanchéité (28), laquelle est configurée pour assurer l'étanchéité de la chambre de moulage (27), configurée sous forme de moule, par rapport à un environnement, notamment en coopérant avec ledit au moins un composant (2).

8. Module électronique comprenant un dispositif de refroidissement (4), au moins un composant électrique (2) et un dispositif (1) d'évacuation de condensat selon l'une des revendications précédentes,
dans lequel le dispositif de refroidissement (4) est disposé sur ledit au moins un composant (2) pour le refroidissement de celui-ci, et ledit au moins un composant (2) présente une surface (3) sur laquelle de la condensation peut se former en raison du refroidissement au moyen du dispositif de refroidissement (4).

9. Module électronique selon la revendication précédente,
comprenant en outre un boîtier de module,
dans lequel le boîtier (20) du dispositif (1) d'évacuation de condensat est disposé notamment entièrement à l'intérieur du boîtier de module et ladite au moins une évacuation de condensat (21, 22, 23) est respectivement configurée pour évacuer le condensat hors du boîtier de module.

10. Procédé de fabrication d'un module électronique selon l'une des deux revendications précédentes et d'un dispositif (1) d'évacuation de condensat selon l'une des revendications 3 à 7,
dans lequel le boîtier (20) est disposé de manière adjacente audit au moins un composant (2) en formant la chambre de moulage (27) et est notamment rendu étanche par rapport audit au moins un composant (2), de sorte que la chambre de moulage (27) est ouverte exclusivement vers la chambre de condensat (24),
dans lequel une masse de coulée, se répartissant par gravité dans la chambre de moulage (27) et remplissant entièrement la chambre de moulage (27), est introduite dans la chambre de moulage (27) à travers une ouverture (29) ménagée vers la chambre de condensat (24), laquelle masse de coulée forme l'élément de conduction thermique (10) après un durcissement de la masse de coulée.
